Europäisches Patentamt

European Patent Office

Office européen des brevets

(19)

(11) EP 0 924 866 A1

(12) DEMANDE DE BREVET EUROPEEN

(43) Date de publication:
23.06.1999 Bulletin 1999/25

(51) Int Cl.⁶: H04B 1/10, H03G 3/34

(21) Numéro de dépôt: 98204160.0

(22) Date de dépôt: 08.12.1998

(84) Etats contractants désignés:
AT BE CH CY DE DK ES FI FR GB GR IE IT LI LU
MC NL PT SE
Etats d'extension désignés:
AL LT LV MK RO SI

(30) Priorité: 15.12.1997 FR 9715880

(71) Demandeur: Koninklijke Philips Electronics N.V.
5621 BA Eindhoven (NL)

(72) Inventeur: Roullet, Pierre, Société Civile S.P.I.D.
75008 Paris (FR)

(74) Mandataire: Chaffraix, Jean
Société Civile S.P.I.D.
156, Boulevard Haussmann
75008 Paris (FR)

(54) **Système de transmission comportant au moins une station satellite et une station de raccordement, station comportant un dispositif de correction de message de parole et procédé pour améliorer la qualité des messages de parole**

(57) Ce système, dans lequel les signaux de parole sont véhiculés par des trames, est formé d'une pluralité de stations satellites (M1, M2,...) et d'une station de raccordement (B1) pour permettre des échanges d'informations sur des lignes téléphoniques, via un commutateru SW. Pour remédier aux effets néfastes des mauvaises transmissions, on propose d'atténuer les signaux de parole lorsque les trames de signaux sont déclarées mauvaises.

Application aux réseaux GSM et DCS.

FIG. 1

**Description**

La présente invention concerne un système de transmission comportant au moins une station satellite et une station de raccordement pour raccorder le système à un réseau commuté, système dans lequel au moins une desdites stations est munie de moyens pour recevoir des messages de parole transmis par trames et d'un dispositif de correction de message de parole pour modifier les trames de signaux de parole en fonction de la qualité de la transmission.

L'invention concerne aussi une station convenant à un tel système munie d'un dispositif de correction de message de parole pour modifier les trames de signaux de parole en fonction de la qualité de la transmission.

L'invention concerne également un procédé pour améliorer la qualité de messages de parole.

L'invention trouve des applications importantes dans le domaine des radiotéléphones portables répondant aux normes du genre GSM et autres (DCS.. etc..).

Un tel système est connu du brevet des Etats-Unis N° 5 687 184 dans lequel au moins une des stations est munie d'un dispositif de correction de messages qui améliore déjà de façon notable la qualité des messages perçus.

La présente invention propose un appareil, du genre précité dans le préambule, qui améliore encore plus, de façon certaine, la qualité des messages reçus dans des conditions de mauvaises transmission.

Pour cela, un tel appareil est remarquable en ce que le dispositif de correction de messages de parole comporte un compteur de mauvaises trames, un circuit atténuateur pour diminuer l'amplitude des signaux de parole pour un contenu dudit compteur supérieur à une valeur prédéterminée.

La description suivante faite en regard des dessins ci-annexés, le tout donné à titre d'exemple non limitatif, fera bien comprendre comment l'invention peut être réalisée.

La figure 1 montre un système conforme à l'invention.

La figure 2 montre une station satellite conforme à l'invention.

La figure 3 montre une station de raccordement conforme à l'invention.

La figure 4 montre l'organigramme représentant les étapes du procédé mis en oeuvre conformément à l'invention.

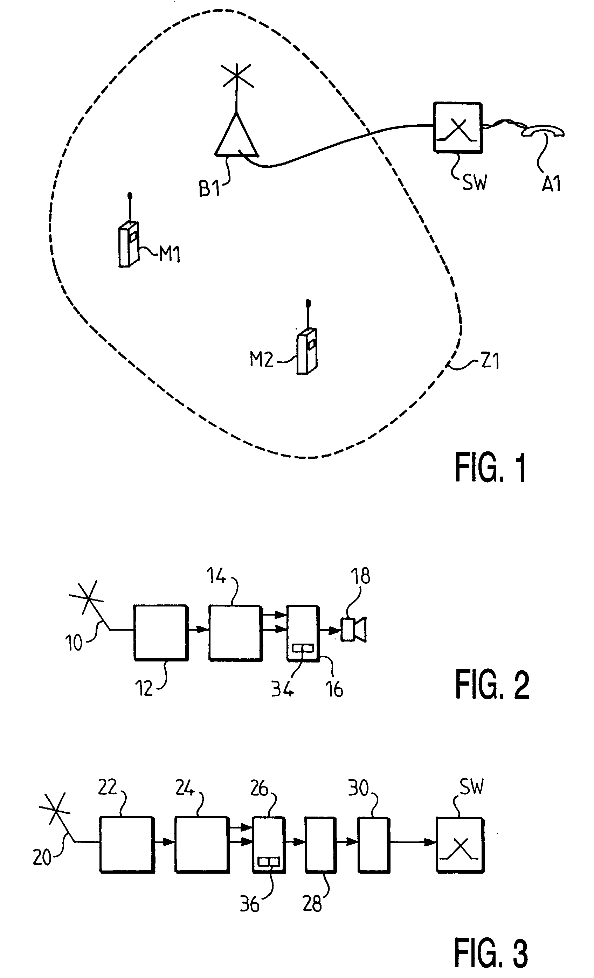

La figure 1 montre schématiquement un système conforme à l'invention. Ce système répondant aux normes GSM, montré à cette figure 1, est formé d'une station de base ou de raccordement B1 et d'une pluralité de stations satellites mobiles ou non M1, M2.... seules les stations M1 et M2 sont montrées sur la figure. La station de raccordement B1 permet l'échange d'informations entre les stations satellites qui sont dans sa zone de couverture Z1, d'une part, et aussi l'échange d'informations avec des abonnés, (par exemple l'abonné A1) appartenant au réseau commuté normal par l'intermédiaire d'un central de commutation SW, d'autre part.

La figure 2 montre schématiquement une station satellite conforme à l'invention. Seule est montrée la partie réception, tout détail concernant la structure d'une telle station peut être trouvé dans le brevet US 5 687 184 précité. Les informations de parole sont véhiculées par des ondes captées par une antenne 10 raccordée à un circuit de réception 12 suivi d'un décodeur de canal 14 qui fournit des informations à un dispositif de correction de message de parole 16. Les signaux de sortie de dispositif sont appliqués à un circuit de restitution de signaux sonores 18 constitué entre autres par un écouteur haut-parleur.

La figure 3 montre schématiquement une station de raccordement conforme à l'invention. Seule est montrée la partie réception, tout détail concernant la structure d'une telle station peut être trouvé dans le brevet US 5 687 184 précité. Cette station comporte les éléments 20, 22, 24, 26 et 28 à rapprocher, respectivement, des éléments 10, 12, 14, 16 et 18 de la station satellite de la figure 1. L'élément 28 cependant ne fournit que des signaux analogiques à sa sortie et ne fournit pas d'ondes sonores comme le circuit 18. Un contrôleur 30 établit un chemin vers le commutateur du réseau commuté SW si besoin est.

Les décodeurs de canal 14 et 24 fournissent des signaux à partir desquels il est possible de déterminer les mauvaises trames et s'il y a lieu d'effectuer un traitement pour que les signaux restitués aux abonnés et aux utilisateurs ne soient pas trop désagréables lorsque les transmissions sont mauvaises, notamment les ruptures de sons qui donnent une impression de paroles "hachées", très désagréables à entendre.

Conformément à l'invention, les dispositifs 16 et 26 comportent, respectivement, un compteur 34 et 36 pour compter le nombre de mauvaises trames et des moyens pour atténuer les signaux sonores lorsque ce nombre excède une certaine valeur, par exemple 4.

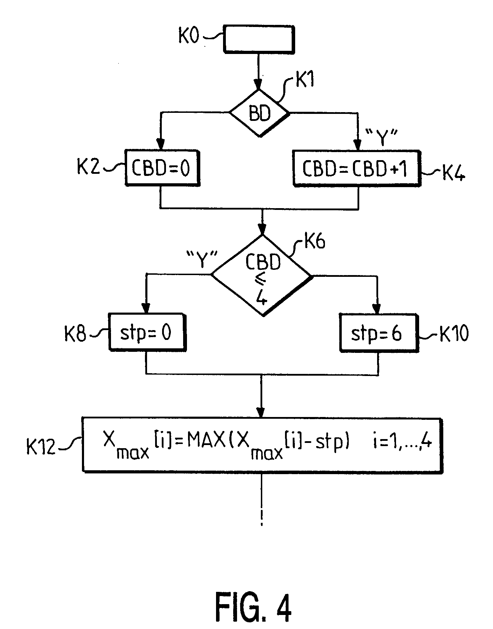

La figure 4 explicite, au moyen d'un organigramme, la mise en oeuvre de l'invention. Sur cet organigramme, la case KO montre la réception d'une trame. La case K1 est un test effectué sur les signaux fournis par le décodeur de canal 14, 24 en vue de déterminer si la trame reçue est une bonne ou une mauvaise trame ; si c'est une bonne trame, on va à la case K2 où le contenu CBD du compteur de mauvaises trames 34, 36 est mis à zéro. Si la trame est mauvaise le contenu de ce compteur est incrémenté d'une unité, case K4. Puis à la case K6 on teste le contenu CBD. Si il excède un certain compte, dans cet exemple 4, alors un pas d'incrémentation stp est mis à 6 (case K10), sinon la valeur est mise à 0 (case K8). De la sorte la valeur de l'amplitude des signaux à appliquer au circuit de restitution de parole prend la valeur indiquée à la case K12 :

$$X_{max}[i] = MAX (X_{max}[i] - stp)\text{pour } i = 1,...4$$

i est le numéro des sous-séquences
$X_{max}[i]$ est l'amplitudes des sous-séquences.

Toutes ces valeurs sont explicitées ou définies dans la norme ETS 300-961.

Ainsi par les mesures proposées par l'invention, on évite d'insérer trop brutalement des échantillons de silence lorsque la transmission devient trop mauvaise.

**Revendications**

1. Système de transmission comportant au moins une station satellite et une station de raccordement pour raccorder le système à un réseau commuté, système dans lequel au moins une desdites stations est munie de moyens pour recevoir des messages de parole transmis par trames et d'un dispositif de correction de message de parole pour modifier les trames de signaux de parole en fonction de la qualité de la transmission, système caractérisé en ce que le dispositif de correction de messages de parole comporte un compteur de mauvaises trames, un circuit atténuateur pour diminuer l'amplitude des signaux de parole pour un contenu dudit compteur supérieur à une valeur prédéterminée.

2. Station satellite convenant à un système selon la revendication 1, comportant un dispositif de correction de messages, caractérisée en ce que le dispositif de correction de messages de parole comporte un compteur de mauvaises trames, un circuit atténuateur pour diminuer l'amplitude des signaux de parole pour un contenu dudit compteur supérieur à une valeur prédéterminée.

3. Station de raccordement convenant à un système selon la revendication 1, comportant un dispositif de correction de messages, caractérisée en ce que le dispositif de correction de messages de parole comporte un compteur de mauvaises trames, un circuit atténuateur pour diminuer l'amplitude des signaux de parole pour un contenu dudit compteur supérieur à une valeur prédéterminée.

4. Procédé pour améliorer la qualité des messages de parole mis en oeuvre dans un système selon la revendication 1 ou dans une station selon la revendication 2 ou 3, caractérisé en qu'il comprend les étapes suivantes :

   - comptage des mauvaise trames,
   - diminution des signaux lorsque le compte de mauvaises trames excède une valeur prédéterminée.

FIG. 1

FIG. 2

FIG. 3

K0 ⌐▭

K1
◇ BD

"Y"

K2 ⌐ CBD=0          CBD=CBD+1 ⌐ K4

K6
"Y"   ◇ CBD
          ≤
          4

K8 ⌐ stp= 0          stp= 6 ⌐ K10

K12 ⌐ $X_{max}[i]=MAX(X_{max}[i]-stp) \quad i=1,...,4$

# FIG. 4

**Office européen des brevets**

**RAPPORT DE RECHERCHE EUROPEENNE**

Numéro de la demande

EP 98 20 4160

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| Y | WO 95 26094 A (OMNIPOINT CORP) 28 septembre 1995 * abrégé * * page 135 - page 138 * * figure 2.4 * | 1-3 | H04B1/10 H03G3/34 |
| A | | 4 | |
| Y | US 5 309 443 A (SCHORMAN ERIC) 3 mai 1994 * colonne 3, ligne 17 - colonne 4, ligne 25; figure 1 * | 1-3 | |
| X | ----- | 4 | |

| | | | DOMAINES TECHNIQUES RECHERCHES (Int.Cl.6) |
|---|---|---|---|
| | | | G10L H04B H03G H04L |

Le présent rapport a été établi pour toutes les revendications

| Lieu de la recherche | Date d'achèvement de la recherche | Examinateur |
|---|---|---|
| LA HAYE | 8 mars 1999 | Ramos Sánchez, U |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**     EP 98 20 4160

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

08-03-1999

| Document brevet cité au rapport de recherche | | Date de publication | Membre(s) de la famille de brevet(s) | | Date de publication |
|---|---|---|---|---|---|
| WO 9526094 | A | 28-09-1995 | CA | 2186031 A | 28-09-1995 |
| | | | EP | 0763300 A | 19-03-1997 |
| | | | JP | 9510844 T | 28-10-1997 |
| | | | US | 5671219 A | 23-09-1997 |
| | | | US | 5818820 A | 06-10-1998 |
| | | | US | 5648955 A | 15-07-1997 |
| | | | US | 5768264 A | 16-06-1998 |
| | | | US | 5787076 A | 28-07-1998 |
| US 5309443 | A | 03-05-1994 | JP | 6061951 A | 04-03-1994 |

EPO FORM P0460

Pour tout renseignement concernant cette annexe : voir Journal Officiel de l'Office européen des brevets, No.12/82